(19) Europäisches Patentamt

European Patent Office

Office européen des brevets

(11) Veröffentlichungsnummer: **0 479 094 A1**

# EUROPÄISCHE PATENTANMELDUNG

(21) Anmeldenummer: **91116206.3**

(51) Int. Cl.5: **H01L 41/08**

(22) Anmeldetag: **24.09.91**

(30) Priorität: **04.10.90 DE 4031702**

(43) Veröffentlichungstag der Anmeldung:
**08.04.92 Patentblatt 92/15**

(84) Benannte Vertragsstaaten:
**CH DE DK FR GB IT LI NL**

(71) Anmelder: **TRIDELTA AG**
**Postfach 2**
**O-6530 Hermsdorf(DE)**

(72) Erfinder: **Meier, Willfried**
**Am Stadion 9**
**O-6530 Hermsdorf(DE)**
Erfinder: **Voigt, Konrad**
**Birkenlinie**
**O-6532 Bad-Klosterlausnitz(DE)**
Erfinder: **Geiss, Wolfgang**
**Tachover Ring 17**
**O-6540 Stadtroda(DE)**
Erfinder: **Richter, Stefan**
**Rosa-Luxemburg-Strasse 12**
**O-6540 Stadtroda(DE)**

(74) Vertreter: **Däsch, Götz**
**W.-Seelenbinder-Strasse 58**
**O-6530 Hermsdorf(DE)**

(54) **Piezoelektrisches Element in Stapelanordnung.**

(57) Die Erfindung betrifft eine Stapelanordnung aus Scheiben, die aus piezoelektrischem oder elektrostriktivem Material bestehen. Dieser Aktuatorstapel findet Anwendung für die mechanische Feinpositionierung im μm-Bereich. Die spezielle Elektrodengestaltung auf den Scheiben führt zu einer starken Abweichung des Wirkquerschnitts des Stapels von seiner beispielsweisen Kreisform. Dadurch kommt es zu unerwünschten Auswirkungen auf die mechanischen Spannungsverhältnisse beim Betrieb des Stapels. Diese innere Spannungen sollen im Betriebsfall minimiert werden. Erfindungsgemäß ist die Querschnittsfläche des Wirkvolumens des Stapels, d.h. seine wirksame Elektrodenfläche, eine auf jeder Scheibe um vier Kreisabschnitte verminderte Kreisform, deren bestimmende benachbarte Sekanten jeweils um 90° versetzt sind, wodurch zusammen mit der Stapelhöhe das aktive, ein einen bezüglich der Wirkachse im wesentlichen rotationssymmetrischen Körper darstellendes Wirkvolumen definiert ist.

Fig. 1

Die Erfindung bezieht sich auf das Gebiet der piezoelektrischen Bauelemente und deren funktionalen Verknüpfung zu elektronischen Baugruppen. Sie betrifft eine Stapelanordnung von deckungsgleich aufeinandergeschichteten, mit Elektrodenschichten versehenen Scheiben aus piezoelektrischen oder elektrostriktiven Materialien. Die Wirkachse und die Längssymmetrieachse sind identisch. Der Aktuatorstapel findet Anwendung für die mechanische Feinpositionierung im µm-Bereich.

Es ist bekannt, Scheiben aus Piezoelektrischem oder elektrostriktivem Material, die an ihren Stirnflächen metallisiert sind, zu stapeln und damit eine elektrische Parallel- und eine mechanische Reihenschaltung der Einzelscheiben zu erzielen.

Dies erfordert eine spezielle geometrische Gestaltung der Elektrodenflächen, wodurch der Wirkquerschnitt des Stapels stark von dem beispielsweise runden Querschnitt des Stapels abweichen kann. Es kommt zu unerwünschten Auswirkungen auf die mechanischen Spannungsverhältnisse beim Betrieb des Aktuatorstapels.
Rechteckige Scheibenquerschnitte haben den Nachteil, daß infolge der bei der piezoelektrischen Ausdehnung des Stapels gleichzeitig senkrecht zur Wirkachse auftretenden Kontraktion des Materials an den Ecken der Einzelscheiben mechanische Spannungen aufgebaut werden, die zum Entstehen von Rissen bzw. bis zur Zerstörung der Scheiben führen.

Die Aufgabe der Erfindung besteht darin, eine Stapelanordnung so zu gestalten, daß innere Spannungen im Betriebsfall minimiert werden. Die Stapelanordnung besteht dabei aus deckungsgleich übereinandergeschichteten, mit Elektrodenschichten auf ihren Stirnflächen aufweisenden Scheiben aus piezoelektrischem oder elektrostriktivem Material. Die Wirkachse des Stapels und seine Längssymmetrieachse sind identisch.

Erfindungsgemäß wird die Aufgabe, wie in den Ansprüchen 1 bis 4 beschrieben, gelöst.

Die Erfindung soll nachstehend an einem Ausführungsbeispiel näher beschrieben werden.
Die dazugehörigen Zeichnungen zeigen:
Fig. 1:    eine Einzelscheibe
Fig. 2:    die erfindungsgemäße Stapelanordnung

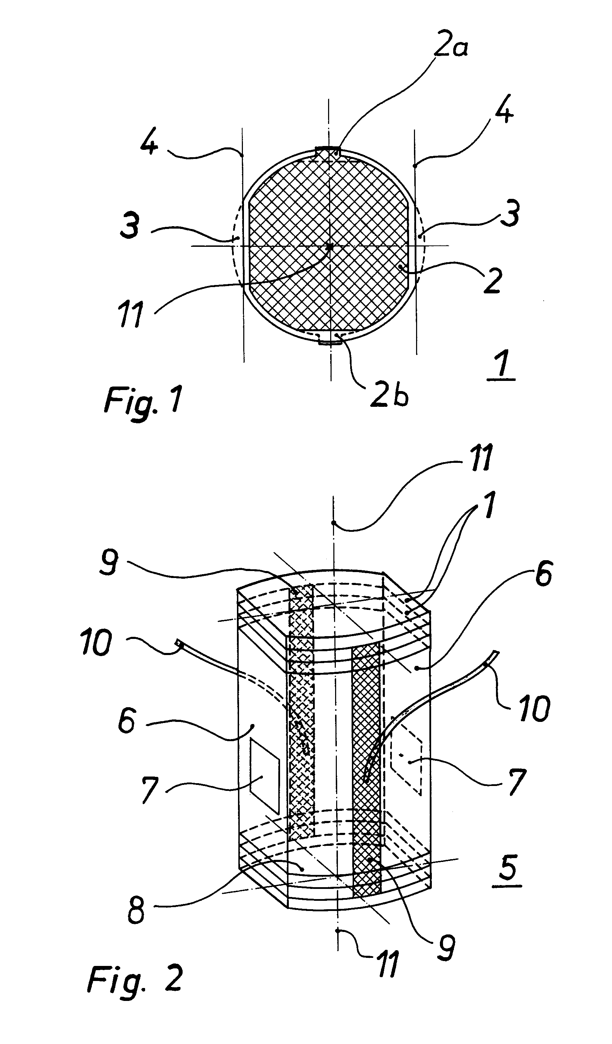

Scheiben 1 aus einem üblichen piezoelektrischen oder elektrostriktiven Material, mit einem Durchmesser von 25 mm und einer Dicke von 0,5 mm sind in einer wie in Fig. 1 dargestellten Weise mit einer Elektrodenschicht 2 belegt. Die Elektrodenmetallisierungen 2 sind an jeweils gegenüberliegenden Stellen 2a, 2b, auf den Rand der Scheibe herausgeführt. Das erfordert zur Gewährleistung der Isolation an diesen Stellen ein Zurücksetzen der jeweiligen Gegenelektrode, so daß deren wirksame Fläche um zunächst zwei Kreisabschnitte 2a, 2b, um maximal 4 % vermindert wird. Zusätzlich wird die Elektrodenfläche um zwei weitere Kreisabschnitte 3 verringert. Die bestimmenden benachbarten Sekanten dieser Kreisabschnitte sind jeweils um ca. 90° versetzt. Durch diese Gestaltung der Elektroden 2 wird zusammen mit der Stapelhöhe das aktive, ein einen bezüglich der Wirkachse 11 im wesentlichen rotationssymmetrischen Körper darstellendes Wirkvolumen definiert.

In dem hier beschriebenen Beispiel sind die Scheiben zusätzlich in ihrer Kreisfläche um zwei Kreisabschnitte 3 vermindert. Die bestimmenden Sekanten 4 liegen dabei zueinander parallel und symmetrisch zur Wirkachse 11 der aufzubauenden Stapelanordnung 5. 30 Stück dieser Scheiben werden unter Verwendung eines Fügemittels übereinandergestapelt, so daß der fertige Stapel zwei parallele Flächen 6 aufweist, die gegebenenfalls noch durch Schleifen und/oder Polieren zur Erzeugung einer hohen Oberflächengüte bearbeitet werden. Ein Planschleifen zur Beseitigung des beim Stapeln der Scheiben entstehenden Versatzes kann sich vorher ebenfalls als notwendig erweisen. Auf diese ebenen Flächen 6 werden nach deren Reinigung Dehnmeßstreifen 7 aufgeklebt und elektrisch kontaktiert, die ein der Dehnung proportionales Regelsignal liefern.

Auf der Mantelfläche (gekrümmt) 8 des Stapels 5 befinden sich um jeweils 90° zu den parallelen Flächen 6 versetzt insgesamt zwei strukturierte Dünnschichtsysteme (Elekrodenbahnen) 9, die zusammen mit den auf die Mantelfläche geführten Elektrodenschichten 2 und mit angebrachten Anschlußdrähten 10 die äußere elektrische Kontaktbarkeit des Stapels gewährleisten.

Zum Schluß wird die gesamte Oberfläche des Stapels, mit Ausnahme der Stirnflächen, schutzlackiert.

Die erläuterte Elektrodenkonfiguration der einzelnen Scheiben und deren beschriebene geometrische Gestaltung ergeben zusammen diese weitgehend symmetrische und kreisähnliche Gestaltung des Wirkquerschnitts (zylinderförmig beim Stapel), der zu einer Minimierung und weitgehend symmetrischen Verteilung der inneren Spannungen führt.

Aufstellung der verwendeten Bezugszeichen

1    Scheiben
2    Elektrodenschicht
2a    an den Rand geführte Elektrodenschicht bzw. freigelassener
2b    Elektrodenkreisabschnitt auf Rückseite
3    fehlender Kreisabschnitt der Scheibe bzw. der Elektrode 2
4    Sekanten der Kreisabschnitte der Scheibe

| | |
|---|---|
| 5 | Stapelanordnung |
| 6 | parallele Flächen des Stapels |
| 7 | Dehnmeßstreifen |
| 8 | gekrümmte Mantelfläche |
| 9 | Elektrodenbahnen |
| 10 | Anschlußdrähte |
| 11 | Wirkachse des Stapels |

**Patentansprüche**

1. Stapelanordnung aus einer deckungsgleichen Übereinanderschichtung von mit Elektrodenschichten versehenen Scheiben aus piezoelektrischen oder elektrostriktiven Materialien bestehend, sowie bestimmt durch die Identität von Wirkachse und Längssymmetrieachse, gekennzeichnet dadurch, daß die Querschnittsfläche des Wirkvolumens des Stapels (5), d.h. seine wirksame Elektrodenfläche (2), eine auf jeder Scheibe (1) um vier Kreisabschnitte ( 2a, 2b, 3) verminderte Kreisform hat, deren bestimmende benachbarte Sekanten jeweils um ca. 90° versetzt sind, wodurch zusammen mit der Stapelhöhe das aktive, ein einen bezüglich der Wirkachse (11) im wesentlichen rotationssymmetrischen Körper darstellendes Wirkvolumen definiert ist.

2. Stapelanordnung nach Anspruch 1, gekennzeichnet dadurch, daß jede einzelne Scheibe (1) und damit auch der Stapel (5) eine kreisförmige Querschnittsfläche aufweisen, die um zwei Kreisabschnitte (3) vermindert ist, deren bestimmende Sekanten (4) vorzugweise symmetrisch zur Wirkachse (11) des Stapels und zueinander parallel verlaufen.

3. Stapelanordnung nach Anspruch 2, gekennzeichnet dadurch, daß die Mantelfläche (8) des Stapelkörpers (5) zwei belotete Dünnschichtelektrodenbahnen (9) trägt, die entsprechend der Form des Zylindermantels gekrümmt sind, deren Flächen mit den parallelen Flächen (6) des Zylinders einen Winkel von 90° ± 15° bilden und jeweils die Elektroden gleicher Polarität elektrisch leitend miteinander verbinden.

4. Stapelanordnung nach Anspruch 2, gekennzeichnet dadurch, daß die veränderte Scheibenform schon vor der Stapelung vorhanden ist.

Fig. 1

Fig. 2

**Europäisches Patentamt**

# EUROPÄISCHER RECHERCHENBERICHT

Nummer der Anmeldung

**EP 91 11 6206**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | PATENT ABSTRACTS OF JAPAN vol. 12, no. 54 (E-583)(2901) 18 Februar 1988, & JP-A-62 199076 (FUJI) 02 September 1987, * das ganze Dokument * — — — | 1-4 | H 01 L 41/08 |
| A | PATENT ABSTRACTS OF JAPAN vol. 10, no. 11 (E-374)(2068) 17 Januar 1986, & JP-A-60 176282 (TOYOTA) 10 September 1985, * das ganze Dokument * — — — | 1-4 | |
| A | PATENT ABSTRACTS OF JAPAN vol. 14, no. 62 (E-883)(4005) 05 Februar 1990, & JP-A-01 282879 (NIPPON SOKEN) 14 November 1989, * das ganze Dokument * — — — | 1-4 | |
| A | EP-A-0 094 078 (NEC) * Anspruch 1; Figuren 7-9 * — — — — — | 1-4 | |

**RECHERCHIERTE SACHGEBIETE (Int. Cl.5)**

H 01 L

Der vorliegende Recherchenbericht wurde für alle Patentansprüche erstellt

| Recherchenort | Abschlußdatum der Recherche | Prüfer |
|---|---|---|
| Berlin | 06 Dezember 91 | MUNNIX S J G |